# EUROPÄISCHE PATENTANMELDUNG

(11) **EP 2 728 086 A1**
(43) Veröffentlichungstag der Anmeldung: **07.05.2014**
(21) Anmeldenummer: 13005186.5
(22) Anmeldetag: 04.11.2013
(51) Int. Cl.: E04D 12/00, E04D 13/16, E04D 13/17

(54) **Vorrichtung zur Herstellung eines belüfteten Daches**

(30) Priorität: 05.11.2012 DE 102012021728
(71) Anmelder: Wille, Werner, 90518 Altdorf (DE)
(72) Erfinder: Wille, Werner, 90518 Altdorf (DE)

(57) **Zusammenfassung**

Die Erfindung betrifft eine Vorrichtung zur Erstellung eines belüfteten Daches.

Der Wasserdampf wird in der kalten Jahreszeit über die Dachgeschossdecke 10, durch die Dampfbremsfolie 20 in die Wärmedämmung 30 und über die diffusionsoffene Unterspannbahn 40 in den ausreichend dimensionierten Luftstrom 50, der sich zwischen der Unterspannbahn 40 und Luftleitfolie 60 befindet, transportiert. Die Luft, die sich unter den Dachziegeln 80 relativ schnell erwärmt, steigt nach oben und erzeugt den Luftstrom 50. Dabei wird der Wasserdampf abtransportiert und die Luftleitfolie und die Unterspannbahn sowie die Dachkonstruktion gekühlt. Damit der Luftstrom 50 entstehen kann, befindet sich direkt unter den Traglatten 70 eine Luftleitfolie 60, die die Luft gezielt nach oben in den Dachfirst leitet. Die ausreichend dimensionierten Öffnungen am Dachfirst 90 transportieren die feuchte Luft ins Freie.

Die Aufheizung der Räume im oberen ausgebauten Dachgeschoss wird wirksam reduziert, Wasserdampf abgeführt und die Luftleitfolie und die Unterspannbahn gekühlt.

## Beschreibung

Die Erfindung betrifft ein Verfahren und Vorrichtung zur Herstellung eines belüfteten Daches, insbesondere zur Kühlung des Daches und des Wasserdampftransports.

Im Laufe der letzten 2 Jahrzehnte hat sich der Aufbau von Dachkonstruktionen von Wohnimmobilien maßgeblich verändert. Mit dem Ausbau der Dachgeschosse zu Wohnräumen wurden die Dachkonstruktionen zusehends anspruchsvoller. Es wurden Wärmedämmmaßnahmen am Dach erforderlich, insbesondere durch die Energieeinsparverordnung.

Bei der Konstruktion des Daches einer Wohnimmobilie wird nicht nur die notwendige Dicke und Ausführung der Dämmung geplant, sondern es wird auch der Wasserdampftransport von innen nach außen berücksichtigt, um keine entstehende Nässe in der Dämmung oder in der Holzkonstruktion vorzufinden. Dabei wird dann noch eine Folie als Dampfbremse vorgesehen.

Der Aufbau des ausgebauten Daches von innen nach außen ist dann z.B. wie folgt:
Decke Dachgeschoss, Sparren, Dampfbremsfolie, Wärmedämmung innerhalb der Sparren, diffusionsoffene Unterspannbahn auf den Sparren, Konterlattung, Traglattung, Dachziegel.

Dabei hat die Dampfbremsfolie die Aufgabe, den Wasserdampfdruck zu reduzieren bevor der Wasserdampf von innen nach außen in die Wärmedämmung diffundiert, um eine Kondensatbildung zu verhindern. Diese Rechnung ist allerdings nur in der kalten Jahreszeit maßgebend, wenn die Außentemperatur deutlich unter der Innentemperatur ist. Im Sommer kehrt sich der Wasserdampftransport allerdings um und zwar von außen nach innen, da es außen wesentlich wärmer ist als innen.

Im Sommer wird dann der Wasserdampf auf dem Weg von außen nach innen in der Dampfbremsfolie abgebremst und bleibt in der Wärmedämmung zurück. Um dies zu verhindern und um auch anfallendes Kondensat (z.B. über Nacht) abzutransportieren, muss einen ausreichende Belüftung unter den Dachziegel stattfinden.

Ein weiterer Vorteil der guten Belüftung unter den Dachziegeln ist, dass sich die Dachziegel und damit die Luft unter den Dachziegeln sowie der Holzkonstruktion des Daches nicht mehr so stark aufheizen kann und damit ein starkes Aufheizen des Dachgeschossraumes (z.B. gegen Abend auf ca. 35-40°C) vermieden wird. Durch gute Belüftung kann die Aufheizung auf ca. 6 K statt 20 K reduziert werden.

Ein weiterer Vorteil der guten Belüftung unter den Dachziegeln ist, dass in Verbindung mit der Aufheizung des Daches unter den Dachziegeln Temperaturen von 80°C und mehr entstehen. Dadurch wird die Unterspannbahn (teilweise zulässig bis 80°C) so stark beansprucht, dass sie sich bereits nach 4-8 Jahren auflöst. Die Funktion eines sicheren Schutzes der Wärmedämmung und der Holzkonstruktion ist dann nicht mehr vorhanden und das Wasser, welches über den First oder beschädigten Dachziegel eindringen kann, dringt in die Holzkonstruktion und die Wärmedämmung ein. Es entstehen dadurch Schäden, die umfangreiche Dachsanierungen nach sich ziehen.

Der Gedanke, dass eine gute Belüftung direkt unter den Dachziegeln der entscheidende Faktor ist, liegt diesen drei Problemen (Wasserdampftransport, Aufheizen, Auflösen der Unterspannbahnen) zugrunde.

In der DIN wird empfohlen, an der Traufe eine Öffnung von 2 Promille der zugehörig geneigten Dachfläche mindestens jedoch 200 cm²/m Dachtiefe und am Dachfirst von 0,5 Promille der zugehörig geneigten Dachfläche mindestens jedoch 50 cm²/m Dachtiefe zu realisieren. Das bedeutet, es werden 2-3 cm Höhe der Konterlattung umgesetzt. Diese Abmessungen setzen aber eine optimale Luftströmung unter den Dachziegel voraus.Erfahrungen, Berechnungen (Druckberechnungen der Aeration, Strömungsdruckverluste durch Konstruktion) und Messungen in der Praxis haben jedoch gezeigt, dass die empfohlenen Werte sowohlk bei steileren als auch bei flacheren Dächern (unter 45°) auch bei optimaler Strömung nicht mehr ausreichend sind, da der entstehende Druck der Aeration zu gering wird. Bei diesen Studien wurde festgestellt, dass bei einer erforderlichen Luftströmung die Konstruktion unter den Dachziegeln der entscheidende Faktor ist. Bei der bisherigen konstruktiven Ausführung entsteht ein sehr hoher Reibungsbeiwert (Luftverwirbelungen) der Luftströmung wegen der quer zum Luftstrom liegenden Traglatten der Dachziegel, sodass der Lufttransport fast zum Erliegen kommt. In den warmen Sommermonaten heizt sich die Luft unter den Dachziegel auf 80°C und mehr auf und zerstört mittelfristig (4-8 Jahre) die Unterspannbahn. Außerdem nimmt diese heiße Luft tagsüber viel Feuchtigkeit auf. Nachts kommt es durch die Abkühlung zu Kondensatausfall, der sich dann in der Dämmung bindet. Tagsüber kann er dann durch den mangelnden Luftstrom nicht komplett abtransportiert werden, er sammelt sich an. Es entsteht eine nasse Wärmedämmung, in der der Widerstandswert der Wärmedämmung deutlich reduziert wird und damit nahezu wirkungslos wird. Weiterhin gibt es Probleme in den Holzsparren, die die Dämmung einschließen, das Holz nimmt Feuchtigkeit auf und wird langsam zerstört bzw. es kommt zu Schimmelbildung.

Weitere Messungen und Berechnungen haben gezeigt, dass die aufgestaute und nicht ausreichend abtransportierte Luft unter den Ziegeln stark aufheizt und diese Hitze weitertransportiert wird über die Wärmedämmung bis zur Geschossdecke sowie über die Sparren, die dann wiederum die Geschossdecke mit anwärmen. Die Folge davon ist, dass sich der Raum im ausgebauten Dachgeschoss nach einer Zeit von ca. 5 - 6 Stunden auf bis zu 35-40 °C aufgeheizt hat. Maßnahmen wie Wärmedämmung, Wasserkühlung des Daches oder auch Amplitudenverschiebung durch Masse haben allerdings die Ursache dieser Aufheizung nicht begegnen können.

Aufgabe der Erfindung ist es nun, eine Dachkonstruktion vorzugeben, die eine ausreichende Belüftung vorsieht, um eine Aufheizung der Dachgeschosse von 20 K auf 6 K zu reduzieren und auch ausreichend Wasserdampf abzutransportieren, um Nässeschäden am Bau zu verhindern. Der kühlende Luftstrom soll direkt die Luftleitfolie und die Unterspannbahn kühlen, um diesen eine lange Lebensdauer zu sichern. Eine weitere Funktion der Erfindung ist es, der Dachkonstruktion eine doppelte Sicherheit zu geben, sollte eine Folie defekt sein, um ein Eindringen von Wasser wirksam zu verhindern.

Diese Aufgabe wird mit dem im kennzeichnenden Teil angegebenen Merkmalen gelöst.

In den Zeichnungen wird anhand zweier Ausführungsbeispiele das erfindungsgemäße Verhalten näher erläutert.

Es zeigen
Fig.1, Dachaufbau mit Decke 10 Dachgeschoss, Dampfbremsfolie 20, Wärmedämmung 30, Unterspannbahn 40, Luftstrom zwischen der Konterlattung 50, Luftleitfolie 60, Traglattung 70, Dachziegel 80
Fig 2, Dachaufbau mit Decke 10 Dachgeschoss, Dampfbremsfolie 20, Wärmedämmung 30, Unterdach 100, Luftstrom zwischen der Konterlattung 50, Luftleitfolie 60, Traglattung 70, Dachziegel 80

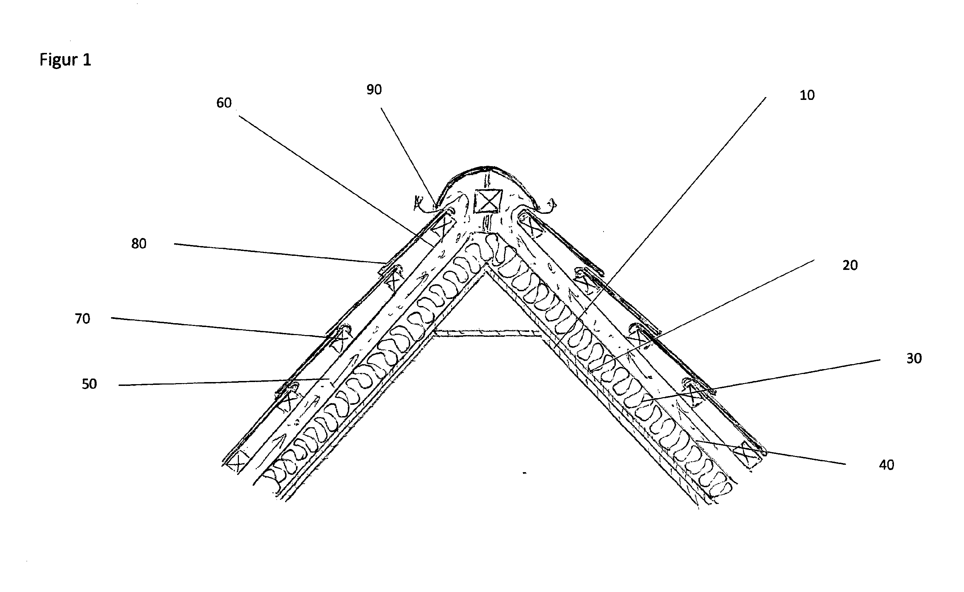

Der Dachaufbau ist in Fig. 1 wie folgt realisiert:
Der Wasserdampf wird in der kalten Jahreszeit über die Dachgeschossdecke 10, durch die Dampfbremsfolie 20 in die Wärmedämmung 30 und über die Unterspannbahn 40 (Unterdach 100) in den ausreichend dimensionierten Luftstrom 50 , der sich zwischen der Konterlattung befindet, transportiert. Die Luft, die sich unter den Dachziegeln 80 relativ schnell erwärmt, steigt nach oben und erzeugt den Luftstrom 50. Dabei wird der Wasserdampf abtransportiert und die Luftleitfolie und die Unterspannbahn sowie die Dachkonstruktion gekühlt. Damit der Luftstrom 50 entstehen kann, befindet sich direkt unter den Traglatten 70 eine Luftleitfolie 60, die die Luft gezielt nach oben in den Dachfirst (Fig 5) ableitet. Die ausreichend dimensionierten Öffnungen am Dachfirst (Fig. 5) 90 transportieren die feuchte Luft ins Freie.

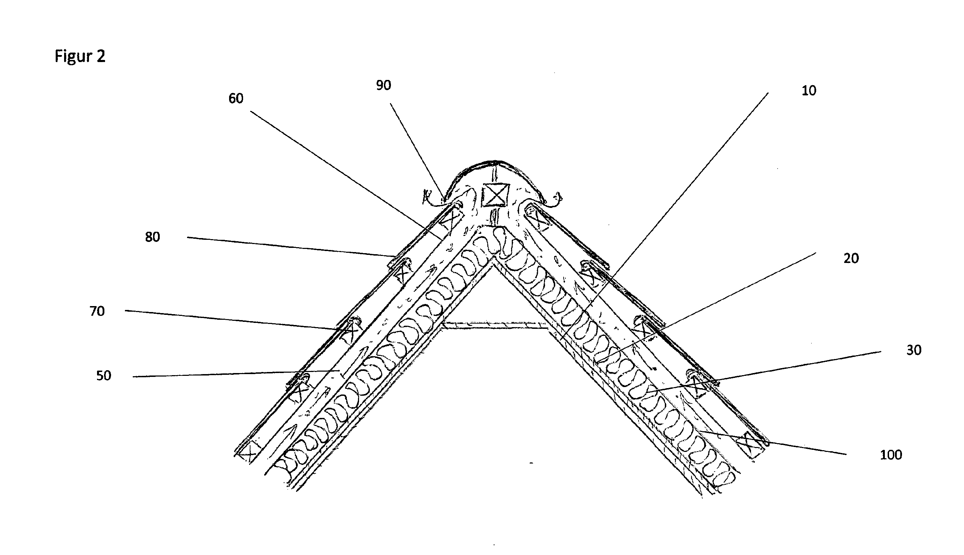

In Fig 2, Dachaufbau mit Decke Dachgeschoss, Dampfbremsfolie, Wärmedämmung, Unterdach, Luftstrom zwischen der Konterlattung, Luftleitfolie, Traglattung, Dachziegel Hier wurde statt der Unterspannbahn ein Unterdach verwendet.

Die Aufheizung der Räume im oberen ausgebauten Dachgeschoss wird wirksam reduziert, Wasserdampf abgeführt und die Luftleitfolie und die Unterspannbahn gekühlt.

## Patentansprüche

1. Vorrichtung zur Erstellung eines belüfteten Daches bestehend
aus 1 Dachgeschossdecke, 1 diffusionsoffene Dampfbremsfolie, 1 Wärmedämmung, 1 diffusionsoffene Unterspannbahn, 1 diffusionsoffene Luftleitfolie
**dadurch gekennzeichnet**
**dass** die diffusionsoffene Luftleitfolie direkt unter den Traglatten angebracht ist und sich der kühlende Luftstrom direkt unter Luftleitfolie befindet.

2. Vorrichtung nach Anspruch 1 **dadurch gekennzeichnet**
**dass** die Vorrichtung statt aus einer Unterspannbahn aus einem Unterdach besteht
